**Europäisches Patentamt**

**European Patent Office**

**Office européen des brevets**

(19)

(11) Veröffentlichungsnummer: **0 134 508**
**B1**

# EUROPÄISCHE PATENTSCHRIFT

(12)

(45) Veröffentlichungstag der Patentschrift:
**13.05.87**

(21) Anmeldenummer: **84108312.4**

(22) Anmeldetag: **14.07.84**

(51) Int. Cl.⁴: **H 02 M 1/06,** H 03 K 17/08

(54) Energiesparschaltung für ein steuerbares elektrisches Ventil.

(30) Priorität: **17.08.83 CH 4474/83**

(43) Veröffentlichungstag der Anmeldung:
**20.03.85 Patentblatt 85/12**

(45) Bekanntmachung des Hinweises auf die Patenterteilung:
**13.05.87 Patentblatt 87/20**

(84) Benannte Vertragsstaaten:
**CH DE GB LI SE**

(56) Entgegenhaltungen:
**DE - A - 2 641 183**
**DE - A - 2 935 660**
**DE - A - 3 215 589**

(73) Patentinhaber: **BBC Aktiengesellschaft Brown, Boveri & Cie., Haselstrasse, CH-5401 Baden (CH)**

(72) Erfinder: **Zürcher, Urs, Kehlstrasse 47, CH-5400 Baden (CH)**

**Beschreibung**

Bei der Erfindung wird ausgegangen von einer Energiesparschaltung für ein steuerbares elektrisches Ventil nach dem Oberbegriff des Patentanspruchs 1.

Mit diesem Oberbegriff nimmt die Erfindung auf einen Stand der Technik von Energiesparschaltungen Bezug, wie er in der DE-A-2 935 660 beschrieben ist. Dort ist ein GTO-Thyristor mit zugehöriger Beschaltung als Löscheinrichtung zur Löschung von Thyristoren in selbstgeführten Stromrichtern eingesetzt. Der GTO-Thyristor ist mit einer Löschspannungsquelle in Reihe geschaltet. Parallel dazu ist eine Diode mit einem Beschaltungskondensator in Reihe geschaltet. An die Verbindung der Diode und des Beschaltungskondensators einerseits und an die Verbindung des Thyristors mit der Löschspannungsquelle andererseits ist die Reihenschaltung einer weiteren Diode und einer Induktivität angeschlossen, wobei die weitere Diode anodenseitig mit der Kathode der Diode verbunden ist. Während der Stromführungsdauer des GTO-Thyristors wird der Beschaltungskondensator mittels der Induktivität entladen, die den grössten Teil der in ihr zwischengespeicherten Energie der Löschspannungsquelle zuführt und den Beschaltungskondensator umlädt. Da diese GTO-Beschaltung eine besondere, mit dem GTO-Thyristor in Reihe geschaltete Löschspannungsquelle benötigt, eignet sie sich nicht als Beschaltung für ein Laststromventil, das zur Gleichstromquelle der Last in Reihe geschaltet ist.

Die Erfindung, wie sie im Patentanspruch 1 definiert ist, löst die Aufgabe, eine Energiesparschaltung für ein steuerbares elektrisches Laststromventil so auszubilden, dass die zwischengespeicherte Energie zumindest teilweise in die Gleichspannungsquelle der Last zurückgespeist werden kann.

Ein Vorteil der Erfindung besteht darin, dass der Laststrom über klar definierte Schaltzeiten besser regelbar ist, da die zwischengespeicherte Energie in die Gleichspannungsquelle der Last gespeist wird. Der Strom durch das steuerbare Laststromventil ist unabhängig von dessen Beschaltung. Ein hoher Entladestoss im Einschaltmoment des Laststromventils wird vermieden. Der Aufwand für die Beschaltung des Laststromventils ist vergleichsweise gering, insbesondere im Hinblick auf Volumen und Kosten der benötigten Bauelemente.

Gemäss einer vorteilhaften Ausgestaltung der Erfindung wird die Umspeicherung der Energie eines Ausschaltentlastungskondensators in eine Energiespardrossel mit einfachen Mitteln in Abhängigkeit von der Spannung am steuerbaren elektrischen Laststromventil oder in Abhängigkeit von dem Laststrom vorgenommen. Der Strom durch die Energiespeicherdrossel wird vorteilhaft in einem Freilaufkreis durch das Laststromventil geleitet.

Zum einschlägigen Stand der Technik wird zusätzlich auf die DE-A-3 120 469 verwiesen. Dort ist über eine Diode parallel zu einem ausschaltbaren Thyristor ein Abschaltentlastungskondensator geschaltet, um beim Ausschalten des Thyristors die zeitliche Änderung der an ihm anfallenden Anoden-Kathodenspannung $dU_{AK}/dt$ unterhalb eines technisch bedingten, vorgebbaren Grenzwertes zu halten. In Reihe zu dem ausschaltbaren Thyristor ist eine Einschaltentlastungsdrossel vorgesehen, um beim Einschalten des Thyristors die zeitliche Änderung seines Anoden-Kathodenstroms $dI_{AK}/dt$ unterhalb eines ebenfalls technisch bedingten, vorgebbaren Grenzwertes zu halten. Sie wirkt beim Einschalten des Thyristors gleichzeitig als Umschwingdrossel und bewirkt ein Umladen des Abschaltentlastungskondensators. Als dritter Energiespeicher ist ein unipolar betriebener Speicherkondensator vorgesehen, der die Energie des Abschaltentlastungskondensators und der Einschaltentlastungsdrossel zeitweise zwischenspeichert und nach dem Abschaltvorgang über eine Freilaufdiode in die Last leitet. Mit dieser Beschaltung wird die in den Blindwiderständen gespeicherte Energie nicht über lineare oder nichtlineare Widerstände in Wärme umgesetzt, sondern in einer Nutzlast nutzbar.

Nachteilig ist, dass ein vergleichsweise voluminöser unipolarer Speicherkondensator benötigt wird, dass die erforderlichen Halbleiterdioden zum Teil hohen Strombeanspruchungen ausgesetzt sind und die zwischengespeicherte Energie nicht über die zwei Anschlussklemmen ins Energienetz zurückgespeist werden kann.

Die Erfindung wird nachstehend anhand von Ausführungsbeispielen erläutert.

Es zeigen:

Fig. 1 ein Prinzipschaltbild einer Energiesparschaltung für ein steuerbares elektrisches Laststromventil mit einem Hilfsthyristor, der in Abhängigkeit von seiner Anoden-Kathodenspannung zündbar ist, und mit einem gestrichelt angedeuteten, zusätzlich vorsehbaren Entkopplungsglied,

Fig. 2 eine Schaltungsvariante mit einem Hilfsthyristor, der in Abhängigkeit vom Laststrom durch das Laststromventil schaltbar ist,

Fig. 3 eine Schaltungsvariante zur Schnellentladung des Ausschaltentlastungskondensators,

Fig. 4 eine Wechselrichterschaltung mit einem Wechselstromverbraucher, vier steuerbaren elektrischen Laststromventilen und einem zusätzlichen Entkopplungsglied,

Fig. 5a Prinzip-Diagramme der Zeitabhängigkeit von Steuerelektroden-Kathodenspannung und Steuerelektroden-Kathodenstrom und

Fig. 5b Prinzip-Diagramme der Zeitabhängigkeit von Anoden-Kathodenspannung und Anoden-Kathodenstrom eines ausschaltbaren Thyristors während des Ausschaltens zur Erläuterung der Wirkung der Energiesparschaltungen.

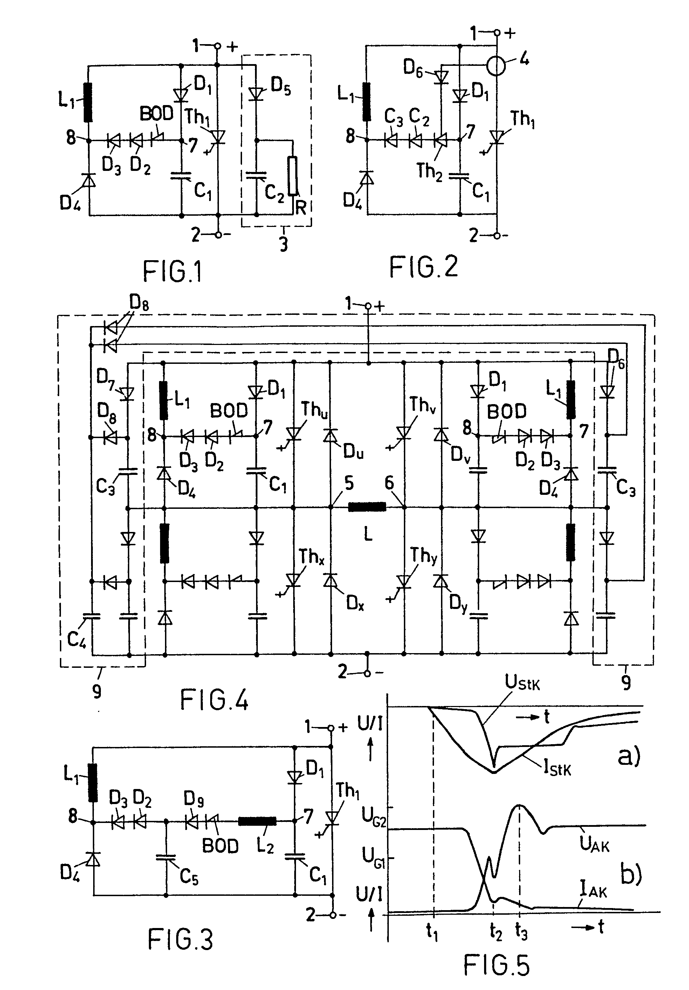

In Fig. 1 ist mit 1 ein positiver Pol und mit 2 ein negativer Pol einer nicht dargestellten Gleichspannungsquelle bezeichnet. Zwischen diesen beiden Polen 1 und 2 ist ein steuerbares elektrisches Laststromventil bzw. ein ausschaltbarer Thyristor (GTO-Thyristor) $Th_1$ geschaltet, wobei die Anode des Thyristors mit dem positiven Pol verbunden ist. Derartige ausschaltbare Thyristoren sind in netz- und zwangskommutierten Schaltungen sowie in Stromrichtern aller Art verwendbar. Bei gleichstromseitig kommutierten Schaltungen können sonst erforderliche Löschkreise für die Laststromthyristoren eingespart werden. Ausschaltbare Thyristoren erfordern sperrspannungsfreie Schaltungen, da sie keine grossen Rückwärtsspannungen vertragen.

Parallel zu diesem ausschaltbaren Thyristor $Th_1$ sind:

1. eine Abschaltentlastungsdiode $D_1$, deren Anode mit dem positiven Pol 1 verbunden ist, in Reihe mit einem Ausschaltentlastungskondensator $C_1$,
2. eine Energiespeicherdrossel $L_1$ in Reihe mit einer Freilaufdiode $D_4$, deren Anode mit dem negativen Pol 2 verbunden ist, und
3. ein Entkopplungsglied 3 geschaltet.

Zwischen einer mit 7 bezeichneten Verbindungsstelle zwischen der Ausschaltentlastungsdiode $D_1$ und dem Ausschaltentlastungskondensator $C_1$ und einer Verbindungsstelle 8 zwischen der Energiespeicherdrossel $L_1$ und der Freilaufdiode $D_4$ sind ein mit BOD bezeichneter Kippspannungs- bzw. Hilfsthyristor in Reihe mit zwei Dioden $D_2$ und $D_3$ geschaltet, die sämtlich in derselben Richtung gepolt sind, wobei die Kathode der Diode $D_3$ mit der Verbindungsstelle 8 elektrisch verbunden ist.

Der Kippspannungsthyristor BOD weist keine Steuerelektrode auf und zündet bei einer konstruktiv vorgebbaren Spannung $U_{AK}$ zwischen Anode und Kathode. Derartige Halbleiterbauelemente mit Kippspannungen im Bereich zwischen 500 V und 4000 V sind im Handel erhältlich und in der Schweizer Firmenschrift BBC Leistungshalbleiter, Technische Mitteilungen, Druckschrift Nr. DHS 90350 D, beschrieben.

Das Entkopplungsglied 3 weist eine Reihenschaltung einer Diode $D_5$, die anodenseitig mit dem positiven Pol 1 verbunden ist, mit einem Kondensator $C_2$ auf, wobei dem Kondensator $C_2$ ein hochohmiger Widerstand R parallelgeschaltet ist.

Die Wirkung der Energiesparschaltung gemäss Fig. 1 soll nun unter Bezugnahme auf die Strom- und Spannungs-Zeitdiagramme von Fig. 5 erläutert werden, vgl. die japanische Firmenschrift der Toshiba Corporation, GTO Application Note, (1983), S. 30. In den Fig. 5a und 5 b sind auf den Ordinaten die Spannung U und der Strom I und auf den Abszissen die Zeit t in willkürlichen Einheiten aufgetragen. In Fig. 5a ist mit $U_{StK}$ der zeitliche Verlauf der Steuerelektroden-Kathodenspannung und mit $I_{StK}$ der zeitliche Verlauf des Steuerelektroden-Kathodenstroms eines ausschaltbaren Thyristors während des Ausschaltens bezeichnet.

Darunter ist in Fig. 5b mit $U_{AK}$ der zugehörige zeitliche Verlauf der Anoden-Kathodenspannung und mit $I_{AK}$ der zeitliche Verlauf des Anoden-Kathodenstroms desselben Thyristors bezeichnet. Zum Zeitpunkt $t_1$ hat nach Eintreffen eines Ausschaltsignals an der Steuerelektrode des ausschaltbaren Thyristors dessen Steuerelektroden-Kathodenstrom $I_{StK}$ 1/10 seines Minimalwertes erreicht, während $U_{AK}$ und $I_{AK}$ noch unverändert sind. Zum Zeitpunkt $t_2$ erreicht der Anoden-Kathodenstrom $I_{AK}$ ein erstes Minimum. Gleichzeitig erreicht die Anoden-Kathodenspannung $U_{AK}$ ein erstes Maximum, das einen konstruktiv bedingten ersten Grenzwert $U_{G1}$ nicht überschreiten darf. $U_{AK}$ erreicht zum Zeitpunkt $t_3$ ein zweites Maximum, das einen ebenfalls konstruktiv bedingten zweiten Grenzwert $U_{G2}$ nicht überschreiten darf. Aus dem Produkt $U_{AK} \cdot I_{AK}$ ergibt sich die Verlustleistung des Thyristors, die bei periodischem Schaltbetrieb zur unerwünschten Erwärmung des Halbleiterbauelements führt und daher möglichst klein gehalten werden muss.

Ist der ausschaltbare Thyristor $Th_1$ gemäss Fig. 1 ausgeschaltet, so lädt sich der Ausschaltentlastungskondensator $C_1$ über die Ausschaltentlastungsdiode $D_1$ auf. Wird der ausschaltbare Thyristor $Th_1$ gezündet bzw. eingeschaltet, so liegt die Spannung des Ausschaltentlastungskondensators $U_{C1}$ auch am Kippspannungsthyristor BOD an, so dass dieser leitend wird. Der Ausschaltentlastungskondensator $C_1$ entlädt sich nun über den Kippspannungsthyristor BOD, die beiden Dioden $D_2$, $D_3$, die Energiespeicherdrossel $L_1$ und den ausschaltbaren Thyristor $Th_1$ bis die Spannung $U_{C1} = 0$ ist. Der Ausschaltentlastungskondensator $C_1$ gibt dabei seine Energie innerhalb 1/4 Periode T des durch $L_1$ und $C_1$ gebildeten Schwingkreises an die Energiespeicherdrossel $L_1$ ab. Für den Schwingkreis gilt:

$$T = 2 \pi \sqrt{L_1 \cdot C_1}.$$

Nachdem $U_{C1} = 0$ geworden ist, wird der elektrische Strom durch die Energiespeicherdrossel $L_1$ aufrechterhalten und fliesst von $L_1$ über $Th_1$ und $D_4$ im Freilauf weiter. Ein weiterer Stromfluss von $L_1$ über $D_1$, BOD, $D_2$, $D_3$ zurück nach $L_1$ ist nicht möglich, weil der Spannungsabfall über $D_1$, BOD, $D_2$ und $D_3$ grösser ist als der über $Th_1$ und $D_4$.

Sperrt nun $Th_1$ wieder, so wird ein Teil der Energie aus $L_1$ zum Aufladen von $C_1$ über $D_1$ und $D_4$ verwendet bis die Spannung $U_{C1}$ gleich der Spannung der Gleichspannungsquelle ist, und ein Teil der Energie wird in die Gleichspannungsquelle zurückgespeist. $C_1$ wird sowohl von $L_1$ als auch von der Gleichspannungsquelle aufgeladen.

Die Kapazität des Ausschaltentlastungskondensators $C_1$ ist so ausreichend gross zu bemessen, dass der Spannungsanstieg $dU_{AK}/dt$ während des Ausschaltens von $Th_1$ so langsam erfolgt, dass der erste Grenzwert $U_{G1}$ nicht überschritten wird. Andererseits ist der Schwingkreis so zu bemessen, dass $U_{C1} = 0$ ist, bevor $Th_1$ ein Ausschaltsignal erhält.

Vorteilhaft wird zusätzlich zu der oben beschriebenen Beschaltung das Entkopplungsglied 3 vorgesehen, mit dem eine Begrenzung des zweiten Maximums von $U_{AK}$ auf den Spannungsgrenzwert $U_{G2}$ erreicht und gleichzeitig eine Überladung von $C_1$ vermieden wird. In Schaltungen, in denen der Laststromzweig durch $Th_1$ keine Energie aufnehmen kann, kann ein Teil der Energie der Energiespeicherdrossel $L_1$ von dem Entkopplungsglied 3 aufgenommen werden. Bei negativer Spannung an der Diode $D_5$ wird der Kondensator $C_2$ aufgeladen, wobei der Kondensatorstrom der Spannung um 90° voreilt. Bei Stromnulldurchgang, der um einen Winkel $\varphi$ früher einsetzt als der Spannungsnulldurchgang an der Diode, sperrt diese, so dass der Kondensator $C_2$ von der Diode $D_5$ entkoppelt ist. $C_2$ entlädt sich nun exponentiell über den Widerstand R. Die Diode wird entsperrt, wenn die Kondensatorspannung den gleichen Wert hat die die Gleichspannungsquelle, vgl. dazu Albert Kloss, Leistungselektronik ohne Ballast, Franzis-Verlag GmbH, München 1980, S. 37 und 38.

Bei der Energiesparschaltung nach Fig. 2 ist das alternativ verwendbare Entkopplungsglied 3 gemäss Fig. 1 nicht dargestellt und der Kippspannungsthyristor BOD durch einen Hilfsthyristor $Th_2$ mit Steuerelektrode ersetzt. Die Steuerelektrode ist über eine Diode $D_6$, deren Kathode mit der Steuerelektrode elektrisch verbunden ist, an einen Stromwandler 4 im Anodenstromkreis des ausschaltbaren Thyristors $Th_1$ angeschlossen, so dass der Hilfsthyristor $Th_2$ in Abhängigkeit vom Anoden-Kathodenstrom $I_{AK}$ von $Th_1$ gezündet bzw. eingeschaltet werden kann. Im Unterschied dazu erfolgte bei der Energiesparschaltung nach Fig. 1 die Zündung des Kippspannungsthyristors BOD in Abhängigkeit von der Anoden-Kathodenspannung $U_{AK}$ von $Th_1$. Im übrigen stimmt die Beschaltung von $Th_1$ mit derjenigen von Fig. 1 überein. Gleiche Teile sind auch in den anderen Figuren mit denselben Bezugszeichen versehen. Wegen der Wirkung der Beschaltung von Fig. 2 wird auf die Ausführung zu Fig. 1 verwiesen.

Diese Energiesparschaltung ist dann besonders günstig einzusetzen, wenn die Wirkung der Beschaltung nur für den Fall des Zündens des eigenen ausschaltbaren Thyristors nützlich ist. Vorzugsweise erfolgt die Zündung des Hilfsthyristors $Th_2$ mit dem Zündimpuls für den ausschaltbaren Thyristor $Th_1$, wobei sich die Diode 6 und der Stromwandler 4 erübrigen.

Fig. 3 zeigt eine Energiesparschaltung, die zur Schnellentladung des Ausschaltentlastungskondensators $C_1$ und damit für relativ hohe Schaltfrequenzen von insbesondere mehr als 400 Hz des ausschaltbaren Thyristors $Th_1$ vorteilhaft ist. Im Unterschied zur Beschaltung von $Th_1$ in Fig. 1 ist zwischen den Verbindungsstellen 7 und 8 eine Drossel $L_2$ in Reihe mit dem Kippspannungsthyristor BOD, einer weiteren Diode $D_9$, die in derselben Richtung gepolt ist wie der Kippspannungsthyristor BOD, und den Dioden $D_2$, $D_3$ geschaltet. Die Kathode der Diode $D_9$ ist über einen Zwischenspeicherkondensator $C_5$ mit der Kathode des ausschaltbaren Thyristors $Th_1$ verbunden. Das alternativ verwendbare Entkopplungsglied 3 gemäss Fig. 1 ist nicht dargestellt.

Nach dem Zünden von $Th_1$ erfolgt ein sehr schnelles Umladen der Ladung von $C_1$ über $L_2$, BOD und $D_9$ nach $C_5$. $C_5$ entlädt sich dann über $L_1$, wie $C_1$ bei der Energiesparschaltung nach Fig. 1. Die Kapazität von $C_5$ ist vorzugsweise 10% grösser zu wählen als die von $C_1$.

Fig. 4 zeigt eine Verwendung von vier Energiesparschaltungen gemäss Fig. 1 in einem Zweiphasenwechselrichter mit einem Wechselstromlastwiderstand L, z.B. einer Motorwicklung. Die steuerbaren Laststromventile bzw. die ausschaltbaren Thyristoren sind hier mit $Th_u$, $Th_v$, $Th_x$ und $Th_y$ bezeichnet. Jedem dieser ausschaltbaren Thyristoren ist eine Diode $D_u$, $D_v$, $D_x$, $D_y$ antiparallel geschaltet. Je zwei ausschaltbare Thyristoren sind mit gleicher Polung und mit zugehöriger Beschaltung hintereinander geschaltet. $Th_u$ ist in Reihe mit $Th_x$ geschaltet und $Th_v$ in Reihe mit $Th_y$. Der positive Pol 1 der Gleichspannungsquelle ist mit den Anoden von $Th_u$ und $Th_v$ verbunden, der negative Pol 2 mit den Kathoden von

$Th_x$ und $Th_y$. Der Wechselstromlastwiderstand L ist über einen Anschlusspunkt 5 mit der Kathode von $Th_u$ und über einen weiteren Anschlusspunkt 6 mit der Kathode von $Th_v$ verbunden.

Anstelle von vier Entkopplungsgliedern 3 gemäss Fig. 1 ist hier ein Entkopplungsglied 9 ohne ohmschen Widerstand R vorgesehen. Dieses Entkopplungsglied 9 weist einen Summenentkopplungskondensator $C_4$ auf, der einerseits mit dem negativen Pol 2 der Gleichstromquelle und andererseits je ausschaltbarem Thyristor $Th_u$, $Th_v$, $Th_x$, $Th_y$ über je eine Diode einer Reihenschaltung aus einer Diode $D_7$ und einem Entkopplungskondensator $C_3$ verbunden ist. Dabei ist diese Reihenschaltung parallel zu dem jeweiligen ausschaltbaren Thyristor geschaltet. Die Anode $D_7$ ist mit der Anode des jeweiligen ausschaltbaren Thyristors $Th_u$, $Th_v$, $Th_x$, $Th_y$ verbunden und die Anode von $D_8$ mit der Kathode von $D_7$.

Das Entkopplungsglied 9 dient zur Begrenzung der Scheitelspannung von $U_{AK}$ zum Zeitpunkt $t_3$, vergleiche Fig. 5b. Für relativ niedrige Schaltfrequenzen der ausschaltbaren Thyristoren von insbesondere weniger als 200 Hz genügt der Summenentkopplungskondensator $C_4$; die Dioden $D_7$ und die Entkopplungskondensatoren $C_3$ können dann entfallen.

Ein Wechselstrom durch L wird durch abwechselndes, periodisches Ein- und Ausschalten der vier ausschaltbaren Thyristoren erzeugt. Sind die Thyristoren $Th_u$ und $Th_y$ eingeschaltet, so fliesst ein Strom durch L vom Anschlusspunkt 5 zum Anschlusspunkt 6. Sind die Thyristoren $Th_v$ und $Th_x$ eingeschaltet, so fliesst ein Strom durch L vom Anschlusspunkt 6 zum Anschlusspunkt 5. Beim Ausschalten der ausschaltbaren Thyristoren entsteht infolge der Induktivität von L eine induktive Gegenspannung an L, die einen Strom über die Dioden $D_x$, $D_v$ bzw. $D_y$, $D_u$ zur Folge hat.

Der Erfindungsgegenstand ist auf das in den Zeichnungen Dargestellte selbstverständlich nicht beschränkt. So können anstelle der Dioden $D_2$, $D_3$ auch zwei Kippspannungsthyristoren BOD oder zwei Hilfsthyristoren $Th_2$ verwendet werden. Wichtig ist, dass der Spannungsabfall in dem Stromzweig zwischen den Verbindungsstellen 7 und 8 grösser ist als in der Diode $D_4$. Es könnte auch die Reihenfolge der Schaltelemente $D_1$ und $C_1$ sowie $L_1$ und $D_4$ vertauscht sein. In diesem Fall müssten die zwischen den Verbindungsstellen 7 und 8 eingebauten gepolten Halbleiterbauelemente mit entgegengesetzer Polung eingebaut werden. Wichtig ist, dass nach einem Zünden des ausschaltbaren Thyristors die auf dem Ausschaltentlastungskondensator $C_1$ gespeicherte elektrische Energie in der Energiespeicherdrossel zwischengespeichert wird und die Spannung $U_{C1} = 0$ ist beim Eintreffen eines Ausschaltsignals für den ausschaltbaren Thyristor.

**Patentansprüche**

1. Energiesparschaltung für ein steuerbares elektrisches Laststromventil ($Th_1$; $Th_u$, $Th_v$, $Th_x$, $Th_y$), insbesondere für einen ausschaltbaren Thyristor,
a) mit einem Ausschaltentlastungskondensator ($C_1$),

b) einem dazu in Reihe geschalteten elektrischen Ausschaltentlastungsventil (D$_1$),

c) mit einer Energiespeicherdrossel (L$_1$) zum Zwischenspeichern der Energie des Ausschaltentlastungskondensators,

d) wobei der Ausschaltentlastungskondensator (C$_1$) über ein Hilfsventil mit der Energiespeicherdrossel (L$_1$) in Wirkverbindung steht, dadurch gekennzeichnet,

e) dass der Ausschaltentlastungskondensator (C$_1$) und das Ausschaltentlastungsventil (D$_1$) parallel zu dem steuerbaren Laststromventil (Th$_1$; Th$_u$, Th$_v$, Th$_x$, Th$_y$) geschaltet sind, wobei das Ausschaltentlastungsventil dieselbe Polung aufweist wie das steuerbare Ventil,

f) dass die Energiespeicherdrossel (L$_1$) in Reihe mit einem Freilaufventil (D$_4$) geschaltet ist,

g) wobei Energiespeicherdrossel und Freilaufventil parallel zu dem steuerbaren Laststromventil (Th$_1$; Th$_u$, Th$_v$, Th$_x$, Th$_y$) geschaltet sind und

h) der Ausschaltentlastungskondensator (C$_1$) über mindestens ein steuerbares Hilfsventil (BOD, Th$_2$) mit der Energiespeicherdrossel (L$_1$) in Wirkverbindung steht,

i) dass der Spannungsabfall in dem Stromzweig zwischen dem Ausschaltentlastungskondensator (C$_1$) und der Energiespeicherdrossel (L$_1$) grösser ist als der Spannungsabfall an dem Freilaufventil (D$_4$) und

j) dass das Abschalten des steuerbaren Laststromventils Th$_1$; Th$_u$, Th$_v$, Th$_x$, Th$_y$) frühestens dann erfolgt, wenn die in dem Ausschaltentlastungskondensator (C$_1$) gespeicherte Energie in die Energiespeicherdrossel (L$_1$) umgeladen worden ist und die Spannung am Ausschaltentlastungskondensator (C$_1$) auf kleine Werte um Null abgesunken ist.

2. Energiesparschaltung nach Anspruch 1, dadurch gekennzeichnet, dass der Ausschaltentlastungskondensator (C$_1$) über das steuerbare Hilfsventil (BOD, Th$_2$) und mindestens ein dazu in Reihe geschaltetes elektrisches Ventil (D$_2$, D$_3$) mit der Energiespeicherdrossel (L$_1$) in Wirkverbindung steht.

3. Energiesparschaltung nach Anspruch 1 oder 2, dadurch gekennzeichnet, dass das steuerbare Hilfsventil ein Thyristor (BOD) ist, der in Abhängigkeit von seiner Anoden-Kathodenspannung steuerbar ist.

4. Energiesparschaltung nach Anspruch 1 oder 2, dadurch gekennzeichnet, dass das steuerbare Hilfsventil ein Thyristor (Th$_2$) ist, dessen Steuerelektrode mit einem Stromwandler (4) im Anodenstromkreis des steuerbaren Laststromventils (Th$_1$, Th$_u$, Th$_v$, Th$_x$, Th$_y$) in Wirkverbindung steht.

5. Energiesparschaltung nach einem der Ansprüche 1 bis 4, dadurch gekennzeichnet, dass parallel zum steuerbaren Laststromventil (Th$_1$, Th$_u$, Th$_v$, Th$_x$, Th$_y$) ein Entkopplungsglied (3) zur Begrenzung der zeitlichen Änderung der Anoden-Kathodenspannung (dU$_{AK}$/dt) an diesem steuerbaren Laststromventil vorgesehen ist.

6. Energiesparschaltung nach Anspruch 5, dadurch gekennzeichnet, dass das Entkopplungsglied eine Reihenschaltung aus einem elektrischen Ventil (D$_5$) und einem Kondensator (C$_2$) aufweist, wobei zu diesem Kondensator (C$_2$) ein Widerstand (R) parallelgeschaltet ist.

7. Energiesparschaltung nach einem der Ansprüche 2 bis 6, dadurch gekennzeichnet,

a) dass das steuerbare Hilfsventil (BOD, Th$_2$) mit einer Drossel (L$_2$) in Reihe geschaltet und

b) diese Reihenschaltung (BOD, Th$_2$; L$_2$) einerseits an eine Verbindungsstelle (7) zwischen Ausschaltentlastungskondensator (C$_1$) und Ausschaltentlastungsdiode (D$_1$) angeschlossen ist und

c) andererseits mit einem Zwischenspeicherkondensator (C$_5$) in Wirkverbindung steht, der mit dem Ausschaltentlastungskondensator (C$_1$) ein Potential (2) gemeinsam hat.

8. Energiesparschaltung nach einem der Ansprüche 1 bis 7, dadurch gekennzeichnet,

a) dass je Phase eines zu erzeugenden Wechselstroms zwei steuerbare elektrische Laststromventile (Th$_u$, Th$_x$; Th$_v$, Th$_y$) mit gleicher Polung der Ventile in Reihe geschaltet sind,

b) dass zu jedem dieser steuerbaren Laststromventile ein elektrisches Ventil (D$_u$, D$_x$; D$_v$, D$_y$) antiparallel geschaltet ist und

c) dass parallel zu den beiden steuerbaren elektrischen Laststromventilen ein Summen-Entkopplungskondensator (C$_4$) vorgesehen ist.

9. Energiesparschaltung nach Anspruch 8, dadurch gekennzeichnet,

a) dass parallel zu jedem steuerbaren elektrischen Laststromventil (Th$_1$, Th$_u$, Th$_v$, Th$_x$, Th$_y$) ein Entkopplungskondensator (C$_3$)

b) in Reihe mit einem elektrischen Ventil (D$_7$) geschaltet ist, das dieselbe Polung wie das steuerbare Laststromventil aufweist,

c) wobei eine Verbindungsstelle zwischen diesem elektrischen Ventil (D$_7$) und diesem Entkopplungskondensator (C$_3$) über ein weiteres elektrisches Ventil (D$_8$) mit dem Summenentkopplungskondensator (C$_4$) in Wirkverbindung steht.

**Claims**

1. Energy economy circuit for a gate-controlled electric load-current valve (Th$_1$; Th$_u$, Th$_v$, Th$_x$, Th$_y$), particularly for a gate turn-off thyristor,

a) including a turn-off voltage limiting capacitor (C$_1$),

b) an electric turn-off voltage limiting valve (D$_1$) connected in series with the capacitor,

c) including an energy storage choke (L$_1$) for temporarily storing the energy of the turn-off voltage limiting capacitor,

d) the turn-off voltage limiting capacitor (C$_1$) being effectively connected to the energy storage choke (L$_1$) via an auxiliary valve, characterized in that

e) the turn-off voltage limiting capacitor (C$_1$) and the turn-off voltage limiting valve (D$_1$) are connected in parallel with the gate-controlled load-current valve (Th$_1$; Th$_u$, Th$_v$, Th$_x$, Th$_y$), the turn-off voltage limiting valve having the same polarity as the gate-controlled valve,

f) the energy storage chocke (L₁) is connected in series with a freewheeling valve (D₄),

g) energy storage choke and freewheeling valve being connected in parallel with the gate-controlled load-current valve ((Th₁; Th_u, Th_v, Th_x, Th_y) and

h) the turn-off voltage limiting capacitor (C₁) being effectively connected to the energy storage choke (L₁) via at least one auxiliary gate-controlled valve (BOD, Th₂),

i) the voltage drop in the current branch between the turn-off voltage limiting capacitor (C₁) and the energy storage choke (L₁) is greater than the voltage drop across the freewheeling valve (D₄) and

j) the gate-controlled load-current valve (Th₁; Th_u, Th_v, Th_x, Th_y) is turned off at the earliest when the energy stored in the turn-off voltage limiting capacitor (C₁) has been transferred into the energy storage choke (L₁) and the voltage across the turn-off voltage limiting capacitor (C₁) has dropped to low values around zero.

2. Energy economy circuit according to Claim 1, characterized in that the turn-off voltage limiting capacitor (C₁) is effectively connected to the energy storage choke (L₁) via the auxiliary gate-controlled valve (BOD, Th₂) and at least one electric valve (D₂, D₃) connected in series with the auxiliary valve.

3. Energy economy circuit according to Claim 1 or 2, characterized in that the auxiliary gate-controlled valve is a thyristor (BOD) which can be gate-controlled in dependence on its anode-to-cathode voltage.

4. Energy economy circuit according to Claim 1 or 2, characterized in that the auxiliary gate-controlled valve is a thyristor (Th₂), the gate control electrode of which is effectively connected to a current transformer (4) in the anode circuit of the gate-controlled load-current valve (Th₁, Th_u, Th_v, Th_x, Th_y).

5. Energy economy circuit according to one of Claims 1 to 4, characterized in that, in parallel with the gate-controlled load-current valve (Th₁, Th_u, Th_v, Th_x, Th_y), a decoupling section (3) is provided for limiting the change in time of the anode-to-cathode voltage (dU_AK/dt) across this gate-controlled load-current valve.

6. Energy economy circuit according to Claim 5, characterized in that the decoupling section displays a series circuit of an electric valve (D₅) and a capacitor (C₂), a resistor (R) being connected in parallel with this capacitor (C₂).

7. Energy economy circuit according to one of Claims 2 to 6, characterized in that

a) the auxiliary gate-controlled valve (BOD, Th₂) is connected in series with a choke (L₂) and

b) this series circuit (BOD, Th₂; L₂) is connected, on the one hand, to a junction (7) between the turn-off voltage limiting capacitor (C₁)( and the turn-off voltage limiting diode (D₁), and

c) on the other hand, is effectively connected to an intermediate-storage capacitor (C₅) which has one potential (2) in common with the turn-off voltage limiting capacitor (C₁).

8. Energy economy circuit according to one of Claims 1 to 7, characterized in that

a) for each phase of an alternating current to be generated, two electric gate-controlled load-current valves (Th_u, Th_x; Th_v, Th_y) are connected in series, the values having the same polarity,

b) an electric valve (D_u, D_x; D_v, D_y) is connected in antiparallel with each of these gate-controlled load-current valves, and

c) an overall decoupling capacitor (C₄) is provided in parallel with the two electric gate-controlled load-current valves.

9. Energy economy circuit according to Claim 8, characterized in that

a) in parallel with each electric gate-controlled load-current valve (Th₁, Th_u, Th_v, Th_x, Th_y), a decoupling capacitor (C₃)

b) is connected in series with an electric valve (D₇) which has the same polarity as the gate-controlled load-current valve,

c) a junction between this electric valve (D₇) and this decoupling capacitor (C₃) being effectively connected to the overall decoupling capacitor (C₄) via another electric valve (D₈).

**Revendications**

1. Circuit économiseur d'énergie pour une soupape de courant de charge électrique commandée (Th₁; Th_u, Th_v, Th_x, Th_y), en particulier pour un thyristor déclenchable, comportant

a) un condensateur de déclenchement (C₁),

b) une soupape de décharge de déclenchement électrique (D₁) connectée en séries avec ce condensateur,

c) une bobine de stockage d'énergie (L₁) pour stocker temporairement l'énergie du condensateur de déclenchement,

d) le condensateur de décharge de déclenchement (C₁) étant en liaison active par l'intermédiaire d'une soupape auxiliaire avec la bobine de stockage d'énergie (L₁), caractérisé en ce que

e) le condensateur de décharge de déclenchement (C₁) et la soupage de décharge de déclenchement (D₁) sont connectés en parallèle à la soupape de courant de charge commandée (Th₁; Th_u, Th_v, Th_x, Th_y), la soupape de décharge de declenchement présentant la même polarité que la soupape de commandée,

f) la bobine de stockage d'énergie (L₁) est connectée en série avec une soupape de roue libre (D₁),

g) la bobine de stockage d'énergie et la soupape de roue libre étant connectées en parallèle avec la soupape de courant de charge commandée (Th₁; Th_u, Th_v, Th_x, Th_y), et

h) le condensateur de décharge de déclenchement (C₁) étant en liaison active par l'intermédiaire d'au moins une soupape auxiliaire commandée (BOD, Th₂) avec la bobine de stockage d'énergie (L₁),

i) la chute de tension dans la dérivation entre le condensateur de décharge de déclenchement (C₁) et la bobine de stockage d'énergie (L₁) est supérieure à la chute de tension au niveau de la soupape de roue libre (D₄), et

j) le déclenchement de la soupape de de courant de charge commandée (Th$_1$; Th$_u$, Th$_v$, Th$_x$, Th$_y$) s'éffectue alors au plus tôt lorsque l'énergie stockée dans le condensateur de décharge de déclenchement (C$_1$) a été transferée et que la tension sur le condensateur de décharge de déclenchement (C$_1$) est descendue à de petites valeurs voisines de zéro. ,

2. Circuit économiseur d'énergie suivant la revendication 1, caractérisé en ce que le condensateur de décharge de déclenchement (C$_1$) est en liaison active par l'intermédiaire de la soupape auxiliaire commandée (BOD, Th$_2$) et d'au moins une soupape électrique (D$_2$, D$_3$) en série avec celle-ci, avec la bobine de stockage d'énergie (L$_1$).

3. Circuit économiseur d'énergie suivant la revendication 1 ou 2, caractérisé en ce que la soupape auxiliaire commandée est un thyristor (BOD) qui peut être commandé en fonction de sa tension d'anode-cathode.

4. Circuit économiseur d'énergie suivant la revendication 1 ou 2, caractérisé en ce que la soupape auxiliaire commandée est un thyristor (Th$_2$) dont l'électrode de commande est en liaison active avec un transformateur d'intensité (4) dans le circuit de courant d'anode de la soupape de courant de charge commandée (Th$_1$, Th$_u$, Th$_v$, Th$_x$, Th$_y$).

5. Circuit économiseur d'énergie suivant l'une quelconque des revendications 1 à 4, caractérisé en ce qu'en parallèle à la soupape de courant de charge commandée (Th$_1$, Th$_u$, Th$_v$, Th$_x$, Th$_y$) est prévu un élément de découplage (3) destiné à limiter la modification dans le temps de la tension d'anode-cathode (dU$_{AK}$/dt) sur cette soupape de courant de charge commandée.

6. Circuit économiseur d'énergie suivant la revendication 5, caractérisé en ce que l'element de découplage comporte un montage en série d'une soupape électrique (D$_5$) et d'un condensateur (C$_2$), une résistance (R) étant connectée en parallèle à ce condensateur (C$_2$).

7. Circuit économiseur d'énergie suivant l'une quelconque des revendications 2 à 6, caractérisé en ce que
a) la soupape auxiliaire commandée (BOD, Th$_2$) est connectée ensérie avec une bobine (L$_2$), et
b) ce montage en série (BOD, Th$_2$; L$_2$) d'une part est connecté à un point de jonction (7) entre le condensateur de décharge de déclenchement (C$_1$) et la diode de décharge de déclenchement (D$_1$), et
c) d'autre part est en liaison active avec un condensateur de stockage intermédiaire (C$_5$) qui a un potential (2) en commun avec le condensateur de décharge de déclenchement (C$_1$).

8. Circuit économiseur d'énergie suivant l'une quelconque des revendications 1 à 7, caractérisé en ce que
a) dans chaque phase d'un courant alternatif à produire, deux soupapes de courant de charge électriques commandées, (Th$_u$, Th$_x$; Th$_v$, Th$_y$) sont connectées en série avec la même polarité,
b) à chaque soupape de dourant de charge commandée est connectée, d'une matière antiparallèle, une soupape électrique (D$_u$, D$_x$; D$_v$, D$_y$), et
c) en parallèle aux deux soupapes de courant de charge électriques commandées est prévu un condensateur de découplage de sommes (C$_4$).

9. Circuit économiseur d'énergie suivant la revendication 8, caractérisé en ce que
a) en parallèle à chaque soupape de courant de charge électrique commandée (Th$_1$, Th$_u$, Th$_v$, Th$_x$, Th$_y$), un condensateur de découplage (C$_3$),
b) est connecté en série avec une soupape électrique (D$_7$) qui présente la même polarité que la soupape de courant de charge commandée,
c) de sorte qu'un point de jonction entre cette soupape électrique (D$_7$) et ce condensateur de découplage (C$_3$) est en liaison active par l'intermédiaire d'une autre soupape électrique (D$_8$) avec le condensateur de découplage de sommes (C$_4$).

FIG.1

FIG.2

FIG.4

FIG.3

FIG.5